(19) Europäisches Patentamt
European Patent Office
Office européen des brevets

(11) **EP 3 671 247 A1**

(12) **EUROPEAN PATENT APPLICATION**

(43) Date of publication:
**24.06.2020   Bulletin 2020/26**

(51) Int Cl.:
***G01R 33/12*** *(2006.01)*

(21) Application number: **18213831.3**

(22) Date of filing: **19.12.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Bruker HTS GmbH**
**63450 Hanau (DE)**

(72) Inventors:
• USOSKIN, Alexander
  63456 Hanau (DE)
• BETZ, Ulrich
  63755 Alzenau (DE)
• SCHLENGA, Klaus
  76149 Karlsruhe (DE)

(74) Representative: **Kohler Schmid Möbus**
**Patentanwälte**
**Partnerschaftsgesellschaft mbB**
**Gropiusplatz 10**
**70563 Stuttgart (DE)**

(54) **METHOD FOR EVALUATING THE ELECTRICAL PROPERTIES OF A HTS SUPERCONDUCTOR**

(57)    The present invention proposes to evaluate the electrical properties, in particular the critical current, of a HTS superconductor (3), in particular of coated conductor tape type, wherein a measurement current (i) is injected into an active part/characterization zone (4) of the HTS superconductor, wherein the active part is cooled, but not reservoirs (1, 2) of the HTS superconductor from and to which the HTS superconductor is wound continuously, and exposing only a fraction of the active part to a magnetic field for testing the electrical properties, with the magnetic field for testing having 1.5 T or more, in particular 2 T or more, and typically being oriented perpendicular to a tape flat side, wherein protection means/buffer devices (20a, 20b) are provided against current sharing with respect to outside the active part, wherein injection of the measurement current is done where the residual magnetic field is at least 3 times lower as compared to the magnetic field for testing and/or the local critical current at the current injection locations is at least three times higher as compared to the critical current at the magnetic field for testing. Preferably, current injection is done where the magnetic field has an opposite sign as compared to the magnetic field of testing. Evaluation of the electrical properties, in particular the evaluation of the critical current, may be done by determining an integral of a voltage drop (U) across the active part or a fraction of the active part, e.g. between two voltage pick-up elements (15a, 15b), as a function of measurement time ($\tau$), in particular comparing the integral value to a critical value (CV) and determining the corresponding time when the critical value was reached. The inventive method is less susceptible to measurement errors.

Fig. 1

EP 3 671 247 A1

## Description

The invention relates to a method for evaluating the electrical properties of a HTS superconductor, in particular a HTS superconductor tape,
wherein the HTS superconductor is exposed to a cryogenic environment of a temperature $T_{env}$,
wherein the HTS superconductor passes through a characterization zone where a magnetic field is applied to the HTS superconductor,
wherein the characterization zone comprises a central region and two peripheral regions through which the HTS superconductor passes,
and wherein the HTS superconductor is supplied with a measuring current by two current exchange elements, wherein one of the current exchange elements contacts the HTS superconductor in each peripheral region.

Such a method is known from L. Rossi et al., "Sample and length-dependent variability of 77 and 4.2 K properties in nominally identical RE123 coated conductors", Superconductor Science and Technology 2016, Vol. 29, No. 5, 054006.

Superconductors can be used to carry an electric current at practically no ohmic losses, for example in order to produce high strength magnetic fields in superconducting magnet coils, or simply to transport the current from a source to a consumer. Superconductor materials have to be cooled down to a critical temperature $T^{crit}$ specific to the superconductor material to become superconducting; cooling a superconductor further below its critical temperature $T^{crit}$ increases the strength of an electrical current (or electrical current density) the superconductor may carry and the strength of a magnetic field the superconductor material may be exposed to while staying superconducting.

In practical applications, an important electric characteristic of a particular superconductor is the maximum electrical current strength that a superconductor may carry at a given temperature (or operating temperature) and a given magnetic field strength (or operating magnetic field strength). This maximum electrical current strength is called the critical current $I^{crit}$.

High temperature superconductors (HTS) require less cooling as compared to conventional low temperature superconductors (LTS), i.e. HTS superconductors have a higher $T^{crit}$ as compared to LTS superconductors; often HTS materials have a $T^{crit}$ of 77 K or higher. In turn, when operating HTS superconductors at temperatures far below their critical temperature $T^{crit}$, they may carry much higher electric currents as compared to LTS superconductors. However, producing HTS superconductors is rather difficult as compared to conventional metallic LTS superconductors, in particular since HTS materials are typically ceramic and require a rather specific chemical composition and microstructure. Commercial HTS superconductors are typically of tape type (also known as coated conductors), wherein a superconductor layer is deposited on a flexible substrate, such as a metal substrate, typically applying one or more buffer layers in between.

HTS superconductors in general include occasional defects that limit the current carrying capacity. Accordingly, the quality of a manufactured HTS should be checked by evaluating their electrical characteristics before using them in practical applications.

L. Rossi et al., see above, have suggested to measure the critical current of a ReBCO type coated conductor every 2 cm. The coated conductor is wound from a first reel to a second reel, passing over roller type current contacts. Between the roller type current contacts, the coated conductor passes voltage taps with an electromagnet in between, and voltage taps with a rotating permanent magnet in between. The whole coated conductor including the reels, the current contacts, the voltage taps and the magnets are located in a LN2 bath; the applied magnetic field was about 0.5 Tesla. Further, it is suggested to predict 4.2 K, high field tape properties from the in-field measurements at 77 K.

Although the setup my give indications of quality variations of a coated conductor, the electrical characterization has been found to be susceptible to measurement errors. In particular, it is difficult to distinguish defects in the material from measurement errors. So making reliable predictions on the behaviour of the coated conductor in practice is difficult to obtain.

US 2007/0149411 A1 proposes to measure electrical characteristics of a superconducting tape at a plurality of positions along its length. The tape is wound between two reels, wherein the tape is guided by guiding rolls through a characterization zone where a pair of permanent magnets may be rotated about the tape. Both non-contact and direct contact testing methods for the tape are proposed, however no details are given where to set up contact elements.

Object of the invention

It is the object of the invention to present a method for evaluating the electrical characteristics of a HTS superconductor that is less susceptible to measurement errors, and in particular allows a more reliable prediction of the behaviour of the HTS superconductor under high field, low temperature conditions.

Short description of the invention

This object is achieved, in accordance with the invention, by a method as introduced in the beginning, characterized in
that the HTS superconductor is continuously translated from a first reservoir through the characterization zone to a second reservoir,
that the HTS superconductor is exposed to the cryogenic environment only in a cryogenic zone, wherein the cryogenic zone includes the characterization zone and wherein the first and second reservoir are located outside the cryogenic zone,
that the HTS superconductor passes two buffer zones where two de-coupling sections are created in the HTS superconductor, with a first decoupling section established between the first reservoir and the characterization zone, and a second decoupling section established between the characterization zone and the second reservoir,
that the magnetic field is chosen such that a maximum magnetic flux density at the HTS superconductor in the central region is $B_{centr}$, with $B_{centr} \geq 1.5$ Tesla, and a maximum magnetic flux density at the HTS superconductor at the current exchange elements is $B_{peri}$, such that, at the temperature $T_{env}$ of the HTS superconductor established by the cryogenic environment in the characterization zone, for a critical current $I_{centr}^{crit}$ of the HTS superconductor in the central region and a critical current $I_{peri}^{crit}$ of the HTS superconductor at the current exchange elements, the following applies:

$$I_{peri}^{crit} \geq 3 * I_{centr}^{crit},$$

and that in each buffer zone, the HTS superconductor is treated such that

- the HTS superconductor becomes normally conducting within the decoupling section, or
- a local critical current $I_{buffer}^{crit}$ of the HTS superconductor in the decoupling section is assumed with $I_{buffer}^{crit} \leq 1/50 * I_{centr}^{crit}$.

The inventive method suggest a plurality of measures to be applied in order to achieve a more reliable electric characterization of the HTS superconductor. In brief, according to the invention, the cryogenic environment is only applied in a cryogenic zone, which in particular does not include the first and second reservoir of the HTS superconductor. This makes the setup simpler, and intrinsically minimizes possible disturbance impact from most of the HTS superconductor. Further, the method suggests to put the current exchange elements (current contacts) in a respective peripheral region where the local critical current is significantly higher than in the characterization zone, typically by having a much lower absolute value of magnetic flux density (or magnetic field strength) there; this avoids measurement errors by a varying electrical contact quality. In turn, it is suggested to apply a relatively high magnetic flux density (or magnetic field strength) at the central region, which has been found to improve predictions on behaviour under higher magnetic fields and at lower temperatures than $T_{env}$. Even further, the invention suggests buffer zones in the setup, and corresponding decoupling sections in the HTS superconductor. These help in blocking leakage currents and antenna-effect currents, and thus avoid corresponding measurement errors. The measures allow a continuous HTS superconductor translation and measurement, which is fast and thorough.
The method establishes one or a plurality of electric characteristics of the HTS superconductor, indicating a superconducting performance of the HTS conductor. Typically, a transition between superconducting state and normally conducting state is monitored or checked for, such as by measuring a critical current or a critical magnetic field as a function of the position along the HTS superconductor.
In accordance with the invention, a relatively high magnetic flux density $B_{centr}$ is used at the HTS superconductor at the central region, namely with $B_{centr} \geq 1.5$ Tesla, which has been found to allow a more accurate estimation of the behaviour of the HTS superconductor at higher fields such as at $B_{high} \geq 10$ Tesla and at lower temperatures such as $T_{low} \leq 4.2$ K. Note that during electrical characterization, the HTS superconductor is typically kept significantly above 4.2K, such as 30 K or above, in particular to save cooling costs. It should be noted that the maximum magnetic flux density of $B_{centr}$ is present only at a relatively short section of the HTS superconductor tape in the central region ("magnetic knife"), such as of only 20 mm in length or less, or even 5 mm in length or less, and the information about the HTS superconductor quality is basically obtained from this section. However, other parts of the HTS superconductor between the current exchange elements or between voltage pick-up elements may still contribute to the measurement result.
However, when using such a high magnetic flus density (or high magnetic field) in the central region, the inventors found that measurements of the electrical properties of the HTS superconductor may be influenced by unexpected (and unwanted) effects in the peripheral regions when doing a continuous conductor translation.
In particular due to unevenness of the HTS superconductor, the "active" electrical contact area of the current exchange elements with the HTS superconductor may vary during superconductor translation significantly. Now when trying to introduce a measurement current into the HTS superconductor by the current exchange elements, the variation of "active" contact area may bring the HTS superconductor to the limits of its (local) current carrying capacity, what may influence the measurement current actually transferred into the HTS superconductor (in particular reduce it at times of bad contact) and a related measurement voltage. These effects at the current exchange elements superimpose with the characteristic effects of the HTS superconductor in the central region of interest, so the measurement of the characteristics of the HTS superconductor may become distorted.
The invention proposes to locate the current exchange contacts such that the electrical exchange elements are placed at the periphery of the generated magnetic field, where (due to a lower magnetic flux density) the critical current (or the critical current density, respectively) is significantly higher than in the central region. Then a varying "active" electrical contact area at the current exchange elements, which leads to a varying current density locally near the current exchange elements, is less likely to come close to the limits of the current carrying capacity of the HTS superconductor. In general, a factor of 3 of increased critical current (or critical current density, respectively) in the peripheral regions as compared to the central region already allows a good protection against unwanted measurement current variations or measurement voltage variations due to the varying electrical contact area at the current exchange elements. However, for long HTS tape lengths and narrow tape widths (where defects have more influence on the superconductor performance), often a higher safety should be achieved by applying higher factors, such as a factor of 5 or more, or a factor of 10 or more, or even a factor of 20 or more for the critical currents (or critical current densities).

Further, buffer zones are established, in accordance with the invention, which generate decoupling sections in the passing HTS superconductor. The buffer zones or the decoupling sections minimize electrical current exchange between HTS superconductor in the characterization zone and outside the characterization zone.

Leakage currents flowing from the current exchange elements through the HTS superconductor away from the characterization zone (e.g. through outside guiding elements or reservoir reels) may disturb the determination or control of the measurement current through the characterization zone. Moreover, HTS superconductor sections outside the characterization zone may act as antenna and collect noise. By means of the buffer zones, current flow to and from the outside of the characterization zone may be stopped or at least brought to a level well below the measurement current of interest. Note that typically, the buffer zones or the decoupling sections start immediately beyond the current exchange elements or the characterization zone, respectively. In the buffer zones, the HTS superconductor is specifically treated in order to block or minimize electric current through the decoupling zones.

The buffer zones may be located partially or completely in the cryogenic zone, but typically are located partially or completely outside the cryogenic zone. Typically, the HTS superconductor in the buffer zone is actively heated (such as with a temperature gradient of 3000 K/m, and typically above room temperature, such as to 40°C or more or 50°C or more) in order to make it non-superconducting and possibly to avoid icing. However, it is also possible to keep the HTS superconductor in a superconducting state in the buffer zones, albeit with a very low critical current $I_{buffer}^{crit}$, such that possible noise and leakage current is very low as compared to the measurement current (which is typically close to the critical current $I_{centr}^{crit}$ at the central region), e.g. by a some heating and/or applying a mediocre jamming magnetic field. A typical decoupling section has a length of at least 5 cm, preferably at least 10 cm, more preferably at least 20 cm. Further typically $I_{buffer}^{crit} \leq 1/100 * I_{centr}^{crit}$. It should be noted that in general, exposing the HTS su-

percondutor simply to ambient temperature is not enough to establish a buffer zone, since the HTS superconductor is often cold enough for superconductivity far away from the cryogenic zone due to cold storage, thermal conduction in the HTS superconductor (which often has a copper sheath or metal substrate) and/or cold gas flows (in particular N2 from a LN2 bath) at the insert and exit openings of a cryostat for the HTS superconductor.

Typically, the magnetic field within the central region is basically homogeneous, and the magnetic field in the peripheral region exhibits a significant gradient. Typically, $B_{centr} \geq 2.0$ Tesla, preferably $B_{centr} \geq 2.5$ Tesla. In the central region, the magnetic field is typically perpendicular to a flat side of the HTS superconductor.

Typically, the HTS superconductor is of tape type, often with a ReBCO type HTS layer (Re=rare earth element, such as Y), and is continuously wound from a first reel to a second reel in solenoid or pancake arrangement during the method, and the HTS superconductor is continuously (or quasi-continuously) measured during such winding. The HTS superconductor typically has a critical temperature of 30 K or more, and preferably 63 K or more, and even more preferably 77 K or more. The HTS superconductor has basically constant cross-sectional dimensions along its long direction (in particular with a constant width and thickness of the HTS layer, such that the critical current density and the critical current are proportional). Typically, a HTS superconductor investigated has a length of 100 m or more, often 1000 m or more.

The current exchange elements (as well as voltage pick-up elements) are typically designed as deflection pulleys, establishing a good electrical contact to the HTS superconductor.

The evaluation of the electrical properties may include an evaluation of critical current, in particular performed via an analysis of a time-dependent integral voltage drop provided at voltage pick-up elements. Alternatively, the evaluation of the electrical properties may include an evaluation of critical magnetic field (or critical magnetic flux density) which also may be performed using an analysis of a time-dependent integral voltage drop provided at voltage pick-up elements. However, other kinds of evaluation are also possible.

The results of the electrical characterization may be used directly for identifying defective HTS superconductors (e.g. by comparing with previous results for defect-free HTS superconductors), or the results of the electrical characterization may be used for estimating electrical properties of the HTS superconductor under higher magnetic field and/or lower temperature conditions.

Preferred variants of the inventive method

In an advantageous variant of the inventive method, $B_{centr}$ and $B_{peri}$ are chosen such that $I_{peri}^{crit} \geq 5 * I_{centr}^{crit}$,

preferably $I_{peri}^{crit} \geq 10*I_{centr}^{crit}$, most preferably $I_{peri}^{crit} \geq 20*I_{centr}^{crit}$. When $I_{peri}^{crit}$ is chosen even larger as compared to $I_{centr}^{crit}$, then the safety margin for compensating for bad electrical contact at the current exchange elements is even higher, and measurement errors due to bad electrical contact become even less likely and less severe.

Preferred is a variant wherein $B_{centr}$ and $B_{peri}$ are chosen with

$$B_{peri} \leq 0.3*B_{centr} ,$$

preferably $B_{peri} \leq 0.2*B_{centr}$, more preferably $B_{peri} \leq 0.1*B_{centr}$, most preferably $B_{peri} \leq 0.05*B_{centr}$. Shaping the magnetic field is a simple way to establish locally different critical currents. It should be noted, though, that the (local) critical current may depend non-linearly on the magnetic flux density.

In a preferred variant, the first decoupling section of the HTS superconductor is established between a last guiding element of the HTS superconductor fed from the first reservoir and a first current exchange element of the current exchange elements, and the second decoupling section of the HTS superconductor is established between a second current exchange element of the current exchange elements and a first guiding element of the HTS superconductor fed to the second reservoir. In this way, leakage currents may be effectively eliminated or at least reduced. The decoupling zones are established at locations that electrically insulate the HTS superconductor currently at the characterization zone, by interrupting the only significant electrical conduction path (i.e. the HTS superconductor) to the next touching structures outside the characterization zone.

Particularly preferred is a variant wherein in the buffer zones, the HTS superconductor undergoes

a) an active heating, in particular an electrical heating, to a temperature $T_{buffer}$, with $T_{buffer} > T_{env}$, preferably $T_{buffer} >$ room temperature, and/or
b) exposure to a jamming magnetic field that suppresses the local critical current $I_{buffer}^{crit}$. Active heating (which is faster and more reliable than simply exposing the HTS superconductor to ambient conditions) is a simple and highly efficient way to make the HTS superconductor normally conducting or at least lowering its critical current to an insignificant level, and thus block leakage and noise currents. Active heating is typically done electrically, what is easy to control, for example using ohmic heating of heating elements close to the HTS superconductor, or done inductively, e.g. by inducing electric currents in normally conductive parts (e.g. a copper sheath or a metal substrate) of the HTS superconductor. It is also possible to expose the HTS superconductor to a jamming magnetic field that brings down the critical current, or in combination with some active heating makes the HTS superconductor normally conducting. Note that establishing a jamming magnetic field is possible without difficulty within the cryogenic zone, if need may be.

In a highly preferred variant, the current exchange elements are positioned such that a local direction of the magnetic field at the current exchange elements is opposite to the direction of the magnetic field in the central region at the HTS superconductor. Opposite means in particular that the component of the local magnetic flux density perpendicular or near to perpendicular to a flat side of the HTS superconductor at the central region (where $B_{centr}$ is present) is of opposite sign as compared to the peripheral region (where $B_{peri}$ is present). In this way, the current carrying capacity of the HTS superconductor at the current exchange elements may be kept high, while keeping a high magnetic field at the central region.

In a preferred variant, a voltage drop $V_{drop}$ at least across the central region of the HTS superconductor is monitored using two voltage pick-up elements, in particular wherein the voltage pick-up elements contact the HTS superconductor between the current exchange elements. Monitoring the voltage drop $V_{drop}$ allows simple and informative electrical characterization; it is indicative of the tape resistance at a given measurement current. Positioning the voltage pick-up elements between the current exchange elements reduces noise. Detection of electrical voltage (voltage drop) is preferably performed with $\sim 10^{-6}$ V accuracy. Then measures for suppression of external electrical and magnetic fields should be taken to provide reproducible and correct measurement results. According to the invention, the following measures can be taken:

(i) magnetic shielding/screening of the voltage characterization area (this differs from the magnetic screening employed for confining the high field area/central region),
(ii) electric screening of the voltage characterization area,
(iii) reduction/minimization of the geometric area of an electric loop used in the voltage evaluation circuit (e.g. via keeping voltage conductors/electrical lines close to each other as well as close to the measured HTS superconductor/tape in the characterization zone in order to suppress induced voltage), and
(iv) employment of electromagnetic screening of the voltage-signal cables/electrical lines coming outside the characterization area. Note that for (i) and (ii), a ferromagnetic and grounded vacuum container of a cryostat inside of which the voltage characterization area (and the characterization zone as a whole) are located may be employed. For (iv), coaxial cables with the outer conductor grounded may be employed.

In an advantageous further development of this variant, the method is conducted such that for the voltage drop $V_{drop}$, the following applies

$$0.5 \, \mu V \leq V_{drop} \leq 2 \, V,$$

preferably $0.5 \, \mu V \leq V_{drop} \leq 1 \, V$,
most preferably $1 \, \mu V \leq V_{drop} \leq 1 \, V$. In accordance with this further development, during a measurement cycle, the voltage is typically varied (ramped) over the intervals listed above. Note that measurement currents are in general about 2-10 A. Then an electrical power in the HTS superconductor will be typically below 10 W/cm², what should be easily removed by e.g. LN2 cooling, so there is no danger of conductor burnout. When using broad ranges (such as >500 mV, or >900 mV), a high signal to noise ratio may be achieved, facilitating detection of (normally conducting) local defects in the HTS superconductor.

Particularly preferred is a further development providing that the voltage pick-up elements are connected to electrical wires, and that at least a part of one or both of the electrical wires is guided within the characterization zone together with the HTS superconductor through a cleavage of a magnetic field generation device. This way, said at least part of one or both of the electrical wires (lines) crosses at least part of the characterization zone exhibiting the maximum magnetic flux density $B_{centr}$. Guiding the electrical wire(s) and the HTS superconductor together (i.e. in close vicinity) avoids collecting electromagnetic interferences (antenna effects). The area encompassed by electrical wires picking up voltage and the HTS superconductor is minimized.

A preferred further development is characterized in that a probing voltage drop as a function of time or location on the HTS superconductor is determined, wherein for determining the probing voltage drop,

- the voltage drop is repeatedly read out at an identical respective magnetic field strength and at an identical respective measurement current value,
- or the voltage drop is integrated during repeated congeneric cycles of sweeps of the measuring current or the magnetic field until an identical measurement current value or an identical magnetic field strength has been reached in each case,

that a first derivative with respect to the time or location of the probing voltage drop is determined, and that a transport of a defect of the HTS superconductor through the characterization zone during the continuous translation is established by identifying a maximum of the first derivative of the probing voltage drop followed by a minimum of the first derivative of the probing voltage drop. A defect (local area of low critical current or of normal conductivity in the HTS superconductor) will cause an addition to the voltage drop as compared to the defect-free HTS superconductor. As long as the defect is in the central region at the highest and locally constant magnetic field, it will cause a constant addition; however it will also contribute to the voltage drop when in the peripheral (transient) regions where a field gradient is present, to a lesser degree. These effects may be well identified using the first derivative of the probing voltage drop with respect to time, i.e. $d\hat{U}(\tau)/d\tau$, or with respect to the location x, i.e. $d\hat{U}(x)/dx$. Note that with a constant translation speed, the time $\tau$ and the location (coordinate) x on the HTS superconductor carry equivalent information. When the defect enters the characterization zone, the first derivative will exhibit a positive peak (maximum), and upon leaving the characterization zone, the first derivative will exhibit a negative peak (minimum), what may be used for simple identification of the defect. Note that for determining the probing voltage drop $\hat{U}$, the voltage drop U may e.g. be read out at or integrated up to identical relative points of time during sweeping cycles of the magnetic field or of the measuring current (see below), or there is simply a constant magnetic field and constant measurement current applied so the probing voltage drop is simply the (original) voltage drop. A particular high reliability may be achieved when using the integrated voltage drop for determining the probing voltage drop; here congeneric cycles of sweeps of the measuring current or the magnetic field have to be applied, with the same sweep speed of the swept variable, with integration up to the same value of the swept variable, and with the other conditions chosen the same in each cycle.

In an advantageous variant of the inventive method, the evaluation of the electrical properties of the HTS superconductor includes

a) applying a constant magnetic field in the characterization zone, applying a sweep of the measuring current, and monitoring a voltage drop at least across the central region along the HTS superconductor, or
b) applying a constant magnetic field in the characterization zone, and regulating and monitoring the measuring current such that a constant voltage drop at least across the central region along the HTS superconductor is obtained, or
c) applying a sweep of the magnetic field in the characterization zone, applying a constant measuring current, and monitoring a voltage drop at least across the central region along the HTS superconductor. These alternatives are comparably simple to do, and allow obtaining a continuous or quasi-continuous information on the quality of the HTS superconductor.

In an advantageous further development of the above variant, the sweep of the measuring current and/or the sweep of the magnetic field applies a saw tooth like waveform. This is simple to do and easy to analyse.

In another further development, the method is conducted such that for a cycle duration CD of the sweep of the measuring current and/or of the sweep of the magnetic field, or a cycle duration CD of regulating the measuring current to re-establish the constant voltage drop, the following applies:

$0.5 \text{ ms} \le CD \le 100 \text{ ms}$. These cycle durations allow high (tape) scanning speeds, in particular of about 100 m/h through 4000 m/h.

In a highly preferred variant, the evaluation of the electrical properties includes evaluating the critical current $I_{centr}^{crit}$ of the HTS superconductor at the temperature $T_{env}$ established by the cryogenic environment and at the maximum magnetic flux density $B_{centr}$. The critical current $I_{centr}^{crit}$ is a simple, easily to understand and easily to obtain information on the HTS superconductor quality.

In a preferred variant, $B_{centr}$ is chosen with

$$B_{centr} \le 6 \text{ Tesla,}$$

preferably $B_{centr} \le 4$ Tesla,
and that $T_{env}$ is chosen with $T_{env} \ge 24$ K,
preferably $T_{env} \ge 77$ K. These conditions are relatively easy to establish (in particular with LN2 or with dry cryostats and/or without using LHe, and with permanent magnets or normally conducting electromagnets), and yet allow a good estimation of the quality of the HTS superconductor, in particular if prediction of high field, low temperature characteristics is intended.

In an advantageous further development of the above two variants, the evaluation of electrical properties further includes estimating a high field low temperature critical current $I_{HFLT}^{crit}$ for the HTS superconductor at a magnetic flux density $B_{high}$ and at a temperature $T_{low}$ based on $I_{centr}^{crit}$,
with

$$B_{high} \ge 3 \cdot B_{centr} ,$$

preferably $B_{high} \ge 10$ Tesla,
most preferably $B_{high} \ge 15$ Tesla,
and further with
$T_{low} \le 4.2$ K. This establishes an information typically highly relevant for practical applications, such as use in a high field magnetic coil cooled in LHe. By means of the inventive measures, a particularly reliably estimation may be achieved. The calculation may include using the correlation $I^{crit} \sim B^{-\alpha}$, in particular with $\alpha$ chosen between 0.7 and 0.8. Typically, $I_{centr}^{crit}$ is first converted by a first correlation function into a critical current at the low temperature Tiow (but still at $B_{centr}$), and is then converted by a second correlation function into $I_{HFLT}^{crit}$.

In a preferred variant, the magnetic field is generated by means of a magnetic field generation device comprising

- a permanent magnet and a soft ferromagnetic material,

- and/or an electromagnet. Permanent magnets and (normally conducting) electromagnets are inexpensive, and both simple and safe in application.

In a highly preferred variant, the magnetic field is shaped using a ferromagnetic screening. In this way, the magnetic field distribution according to the invention, in particular establishing a comparably low magnetic field strength at the current exchange elements, is achievable in a simple and inexpensive way. Typically, the ferromagnetic screening comprises a casing encompassing a magnetic field generation device and the central region, wherein the peripheral regions are located outside the ferromagnetic screening.

Further within the scope of the present invention is an apparatus for evaluating the electrical properties of a HTS superconductor, in particular a HTS superconductor tape, designed for performing an inventive method as described above. Typically, the apparatus comprises a cryostat, inside of which a magnetic field generation device, two current exchange elements, and two voltage pick-up elements are located; further the cryostat typically comprises a cooling device for establishing the cryogenic temperature $T_{env}$ inside the cryostat. Further, the apparatus typically comprises two buffer devices for establishing the buffer zones, typically at the exits of the cryostat for the HTS superconductor, and often designed as electric heaters. Further, the apparatus typically comprises a first reel and a second reel for winding a HTS superconductor from the first reel through the first buffer device, the cryostat and the second buffer device to the second reel, and a motor system allows a motorized winding. Further, the apparatus typically comprises a controller device for conducting continuous or quasi-continuous electrical measurements of the HTS superconductor tape during its continuous transport / winding, and possibly for analysing the measured data, including prediction of a high field, low temperature characteristic of the HTS superconductor. The inventive apparatus allows a reliable electric characterization of the HTS superconductor.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

Drawing

The invention is shown in the drawing.

Fig. 1      shows a schematic cross-section of an embodiment of an inventive apparatus for conducting a variant of the inventive method;

Fig. 2a illustrates a characterization zone, used in a variant of the inventive method, with an electrical line of a voltage pick-up element running through the magnetic field generation device;

Fig. 2b shows a schematic diagram for a magnetic field distribution in the characterization zone, for use with the inventive method;

Fig. 3 illustrates a characterization zone, used in another variant of the inventive method, with two electrical lines of voltage pick-up elements running through a respective half of the magnetic field generation device;

Fig. 4 shows a schematic diagram of the course of a measurement for use in the inventive method, of i-sweep type;

Fig. 5 shows a schematic diagram of the course of a measurement for use in the inventive method, of B-sweep type;

Fig. 6 shows a schematic diagram of the course of a measurement for use in the inventive method, of constant voltage type;

**Fig. 7** shows a schematic diagram of the first derivative of the probing voltage drop $d\hat{U}(\tau)/d\tau$ as a function of time $\tau$ when a defect passes the characterization zone.

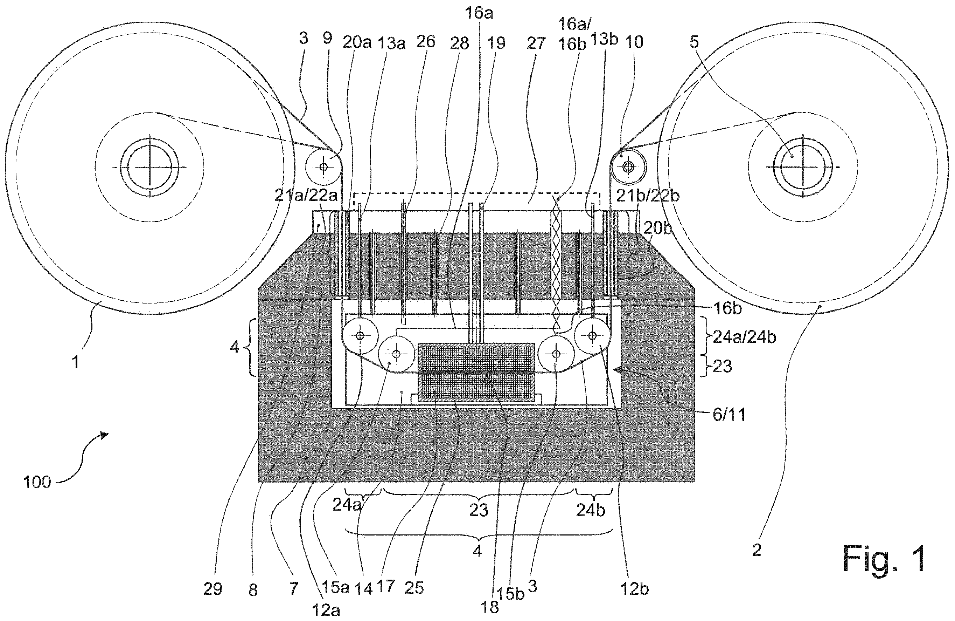

**Fig. 1** shows in a schematic cross-section an inventive apparatus 100 for carrying out the inventive method by way of example.

The apparatus 100 comprises a first reservoir 1 and a second reservoir 2 for a tape type HTS superconductor 3. The HTS superconductor 3 is guided from the first reservoir 1 over a (last first side) guiding element 9 of deflection pulley type through a characterization zone 4 where electric properties of the HTS superconductor 3 are measured, further over a (first second side) guiding element 10 of deflection pulley type and onto the second reservoir 2. The first and second reservoir 1, 2 are designed here with reels, wherein the second reservoir 2 resp. its reel comprises a reel drive 5, here with an electric motor. The first and second reservoir 1, 2 and guiding elements 9, 10 are arranged on a respective support or supports (not shown in detail here, for simplicity), preferably on a common outer base frame. The guiding element 10 comprises a tension sensor (not shown in detail).

The characterization zone 4 is located within a cryogenic zone 6, which is formed by the interior of a cryostat, here comprising a cryovessel 7 and a thermally insulating cover 8. The interior of the cryostat is here at least partially filled with liquid nitrogen (LN2) (not shown here for simplicity). The cryostat is connected to a cryocooler (not shown here for simplicity) to cool its interior and here to safe LN2; alternatively, LN2 can be added more often.

Accordingly, the HTS superconductor 3 is locally exposed to a cryogenic environment 11, namely when passing the cryogenic zone 6, but for the most part, the HTS superconductor 3 is exposed to ambient conditions (room temperature of about 20°C), in particular at the first and second reservoirs 1, 2. The cryogenic environment 11 has a temperature $T_{env}$ of here 77 K, which is assumed by the HTS superconductor 3 within the cryogenic zone 6.

On top of the cover 8 of the cryostat, there is arranged a base plate 29 with a number of feedthroughs for accessing the equipment inside the cryostat. In particular, there are a number of pendants 28 which suspend an inner base frame 14 ("lower basis") located in the interior of the cryostat. The pendants 28 are typically made of thin stainless steel which provides reduction of cryo loss. Further, there is a LN2 nozzle for re-filling of the cryostat with LN2 and a level sensor 26 extending through the cover 8 of the cryostat.

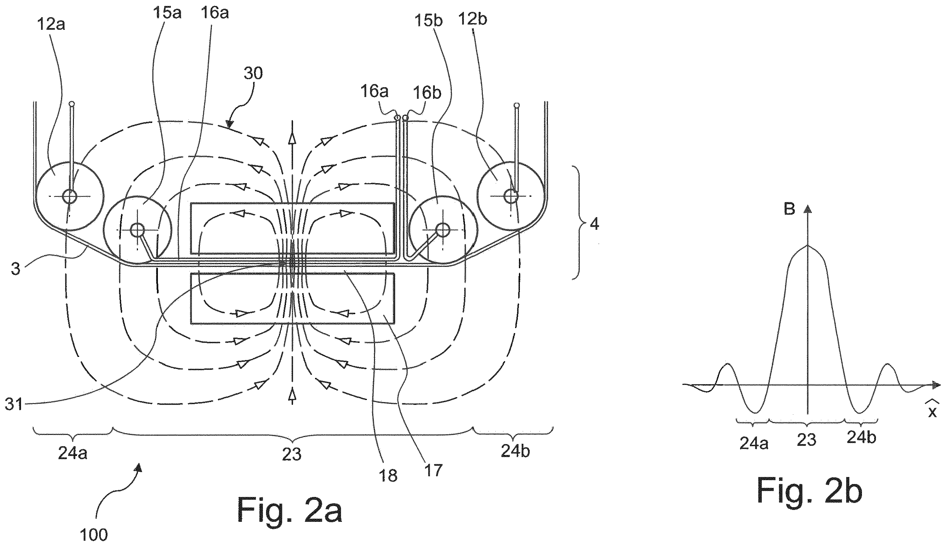

The inner base frame 14 carries a magnetic field generation device 17, here constructed as a normally conducting electromagnet, having a cleavage 18 through which the HTS superconductor 3 passes. Electrical lines (current leads) 19 provide the magnetic field generation device 17 with operating current; the electric lines 19 pass through the cover 8. The magnetic field generation device 17 generates a magnetic field, both in a central region 23 (intended for the measurement) and in peripheral regions 24a, 24b (as an unintended stray field) in the characterization zone 4. The magnetic field distribution is set with the help of a ferromagnetic screening 25, which encompasses the magnetic field generation device 17 here. The generated magnetic field is strongest at a magnetic center within the central region 23 (compare also Fig. 2a); there the HTS superconductor 3 is exposed to the maximum flux density $B_{centr}$, here with $B_{centr}$ = 2.5 Tesla.

Further, the inner base frame 14 carries a first current exchange element 12a and a second current exchange element 12b, which are designed as deflection rollers here. The current exchange elements 12a, 12b are connected to electric lines (currents leads) or wires 13a, 13b which go straight upwards, passing through the cover 8. The current exchange elements 12a, 12b contact the HTS superconductor 3 in the peripheral regions 24a, 24b for applying a measurement current. Here, the maximum magnetic flux density is $B_{peri}$. In the example illustrated, $B_{peri}$=0.25 Tesla.

Further, the inner base frame 14 carries a first voltage pick-up element 15a and a second voltage pick-up element 15b, which are also designed as deflection rollers here. The voltage pick-up elements 15a, 15b are connected to electrical lines (voltage leads) or wires 16a, 16b; in the example shown, electrical line 16a is guided in parallel to the HTS superconductor 3 outside magnetic field generation device 17, and above the second voltage pick-up element 15b, the electrical lines 16a, 16b are twisted and pass through the cover 8. The voltage pick-up elements 15a, 15b are located, with respect to the motion of the tape, between the current exchange elements 12a, 12b.

Introduction of the HTS superconductor 3 into the characterization zone 4 (and here also the cryogenic zone 6) is done via buffer devices 20a, 20b. The buffer devices 20a, 20b are here designed with electrical tape heaters, which establish buffer zones 21a, 21b inside of which the HTS superconductor 3 is heated, here to a temperature $T_{buffer}$ above ambient temperature, in the example shown to a temperature of about 50°C. The buffer zones 21a, 21b cause respective decoupling sections 22a, 22b of the HTS superconductor 3, where the HTS superconductor is safely normally conducting (and not superconducting), and therefore electric current transfer is minimized. The decoupling sections 22a, 22b here have a lengths (in tape direction) of about 50 cm here.

In the course of evaluating the electrical properties of the HTS superconductor 3, the HTS superconductor 3 is exposed to an electrical measurement current via the current exchange elements 12a, 12b and exposed to a magnetic field up to $B_{centr}$ in the central region 23. The voltage drop $V_{drop}$ across the central region 23 is measured via the voltage pick-up elements 15a, 15b. Thanks to the low value of $B_{peri}$ as compared to $B_{centr}$, the (smallest) local critical current $I_{centr}^{crit}$ in the central region 23 is here more than 5 times smaller than the (highest) local critical current $I_{peri}^{crit}$ in the peripheral regions 24a, 24b, i.e. $I_{centr}^{crit} \leq 5* I_{peri}^{crit}$. The measurement current, the voltage drop and the magnetic field generated by the magnetic field generation device 17 and here also the LN2 level are controlled and/or monitored via an electronic controller device 27, which is shown as a single unit here, but which may also comprise a number of subunits such as magnet current control box, a measurement current distribution box, a voltage signal box and a LN2 distribution box.

Fig. 2a illustrates another example of an inventive apparatus 100 for carrying out the inventive method. For simplicity, only the interior of the cryostat is shown, and only the major differences with respect to Fig. 1 are explained.

In the example shown, the HTS superconductor 3 is guided by current exchange elements 12a, 12b and voltage pick-up elements 15a, 15b through the cleavage 18 of the magnetic field generation device 17. In addition, also the electric line 16a, which is connected to the first voltage pick-up element 15a, is guided through the cleavage 18, in close vicinity and parallel to the HTS superconductor 3. On the right side of the magnetic field generation device 17, the electric line 16a is guided to the top, in close vicinity of and in parallel with (or alternatively twisted with) the electric line 16b, which is connected to the second voltage pick-up element 15b. By this means, antenna effects of the electrical lines 16a, 16b are minimized.

Further, the field lines 30 of a typical magnetic field generated by the magnetic field generation device 17 are shown. Field lines 30 in the central region 23 have a high density, in particular near the magnetic center 31, where the magnetic field strength is highest (and $B_{centr}$ acts on the HTS superconductor 3, typically in a direction perpendicular to the plane/flat side of the tape). In contrast, in the peripheral regions 24a, 24b, where the current exchange elements 12a, 12b contact the HTS superconductor 3, the field lines 30 have a relatively low density. The maximum magnetic field acting on the HTS superconductor there (with corresponding $B_{peri}$ acting on the HTS superconductor 3 at the current exchange elements 12a, 12b, typically in a direction having some inclination to the plane/flat side of the tape) is far below $B_{centr}$ in terms of absolute value.

In the example shown, the magnetic field strength simply falls off monotonically away from the magnetic center 31. However, in practice, the magnetic field often changes its sign several times when going away from the magnetic center 31. Such a behavior may be promoted by appropriate magnet design or ferromagnetic screening design. In this case, it is advantageous to place the current exchange elements 12a, 12b or the respective peripheral regions 24a, 24b in areas where the sign of the magnetic field is opposite to the sign at the magnetic center 31. In this way, a higher magnetic field may be applied to the HTS superconductor 2 for measurement purposes, while at the same time keeping the critical currents $I_{peri}^{crit}$ in the peripheral regions 24a, 24b high. Fig. 2b illustrates such a magnetic field (compare axis to the top, illustrating the magnetic flux density B, as a function of location $\hat{x}$), and the peripheral regions 24a, 24b and central region 23. The magnetic center is here at x=0, with direction $\hat{x}$ extending along the cleavage of the magnetic field generation device, along with the HTS superconductor.

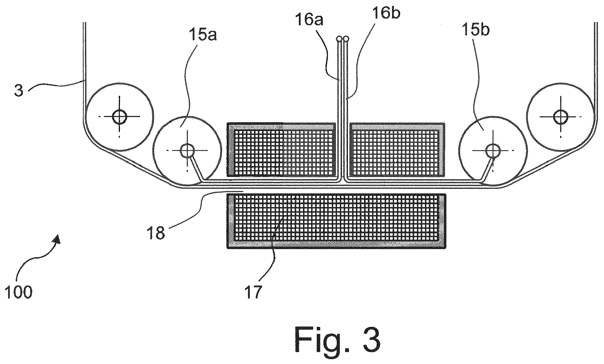

Fig. 3 illustrates an alternative design of an inventive apparatus 100 for carrying out the inventive method, similar to the apparatus shown in Fig. 2a. Only the major differences are explained.

In the embodiment shown, the electrical lines 16a, 16b connected to the voltage pick-up elements 15a, 15b both are guided through the cleavage 18 of the magnetic field generation device 17, but only to its center. At its center, the electrical lines 16a, 16b are guided to the top in close vicinity and in parallel to each other (or alternatively twisted) through the magnetic field generation device 17. This design has a higher symmetry as compared to the design of Fig. 2a, but requires a feedthrough of lines 16a, 16b through the upper part of the magnetic field generation device ("magnet").

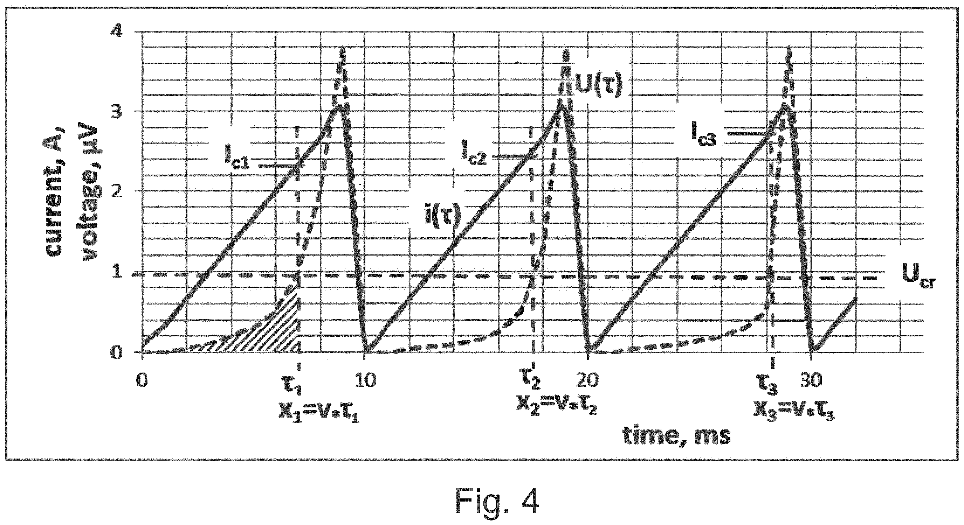

Fig. 4 illustrates a procedure for measuring the electrical properties of a HTS superconductor as a function of time τ (illustrated to the right), in an i-sweep variant. The measurement may be performed, for example, on an apparatus as shown in Fig. 1. Note that the time τ correlates with the location x via the (continuous) translation speed v of the HTS superconductor, with $x=v*\tau$.

In this setup, the measurement current i (compare full line) applied via the current exchange contacts is varied in a saw-tooth like manner as a function of time $\tau$. Over a period (cycle duration) of here 10 ms, the measurement current $i(\tau)$ is increased linearly from zero to about 3 A here and back to zero. The magnetic field is kept constant. The voltage U between the voltage pick-up elements is measured as a function of time, see voltage $U(\tau)$ (compare dashed line). The example illustrates here three measurement cycles (see indices j=1, 2, 3).

For low measurement currents i, the HTS superconductor is practically completely superconducting, and the voltage drop-off is practically zero. However, when the measurement current i approaches the critical current (for the given temperature $T_{env}$ and $B_{centr}$), the voltage U increases in an approximately exponential way. Note that the critical current varies locally due to variations in the structure of the HTS superconductor.

In the example shown, it is assumed that the superconductor has reached its critical current when the voltage U has reached a critical level $U_{cr}$. For each cycle j=1, 2, 3, the time $\tau_j$ is indicated at which $U(\tau)=U_{cr}$. At this point of time, the momentary measurement current $I_{cj}$ is determined, which is considered as the local critical current (at the magnetic center in the central region of the HTS superconductor at $B_{centr}$ and at $T_{env}$ applied during the measurement). The corresponding location along the tape length is determined as $x_j=v*\tau_j$. In this way, a table of critical currents $I_{cj}$ as a function of location $x_j$ can be obtained.

Alternatively, beginning from the start of each cycle, an integral $\int U(\tau)d\tau$ can be determined. The point of time $\tau_j$ in each cycle j when the integral value reaches a critical value CV is determined, i.e. $\tau_j$ is determined for

$$\int_{\tau 0}^{\tau j} U(\tau)d\tau = CV,$$

which with $\tau_0$ being the start of the respective cycle. For illustration, the integral area of

$$\int_0^{\tau 1} U(\tau)d\tau$$

is illustrated with a hatching. When the area of the hatching has reached CV, the point of time $\tau_j$ has been reached, and the measurement current $i(\tau_j)$ at this point of time can be considered as the critical current $I_{cj}$ at the respective location $x_j=v*\tau_j$. Determining $\tau_j$ via the integral $\int U(\tau)d\tau$ is somewhat more complex as compared to a simple limit value $U_{cr}$, but thus a higher reliability in determining $I_{cj}$ resp. $I_{cent}^{crit}(x)$ can be obtained.

Further, a probing voltage drop $\hat{U}(\tau)$ may be determined, for example by reading out the voltage drop $U(\tau)$ in each cycle j=1, 2, 3 at a fixed $\Delta\tau$ after the beginning $\tau_0$ of said cycle, or alternatively by determining in each

$$\int_{\tau 0}^{\tau 0+\Delta\tau} U(\tau)d\tau,$$

cycle the integral i.e. from the beginning $\tau_0$ of the cycle until $\Delta\tau$ has elapsed. The first de-

rivative $d\hat{U}(\tau)/d\tau$ of the probing voltage drop $\hat{U}(\tau)$ may be used for identifying defects in the HTS superconductor passing the characterization zone. In this sense, by smooth and continuous translation of the tape, the time $\tau$ corresponds to a tape coordinate x in the longitudinal direction. On the other hand, the voltage response U is formed as an integral of "elementary" voltage drops occurring between voltage pick-up elements as

$$U = \Delta x^{-1} \int_{x0}^{x0+\Delta x} U(x,B)dx,$$

with x: (longitudinal) tape coordinate/location on the tape, and xo: integral start position (position of first voltage pick-up element at measurement time), and $\Delta x$: tape length between the voltage pick-up elements; note that U is here a function of xo, which in turn is a function of time. The latter integral allows to take into account the entire voltage drop including minor drops occurring in the areas with reduced flux density. In this way, improved precision of characterization may be achieved.

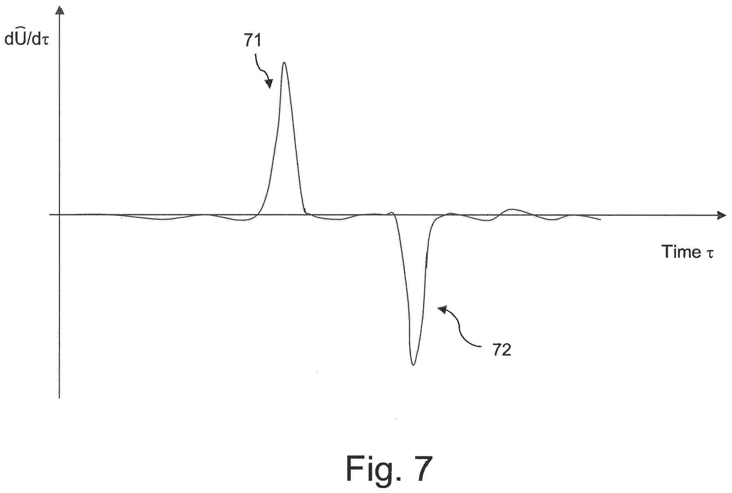

**Fig. 7** shows a typical first derivative $d\hat{U}(\tau)/d\tau$ as a function of time during passing of a defect. When the defect enters the characterization zone, a maximum 71 can be observed, and when the defect leaves the characterization zone, a minimum 72 can be observed. Note that the time $\tau$ correlates with the location x on the HTS superconductor via the translation speed v with $x=v*\tau$.

It should be noted that the probing voltage drop $\hat{U}(\tau)$ can analogously be investigated in the B-sweep variant discussed below.

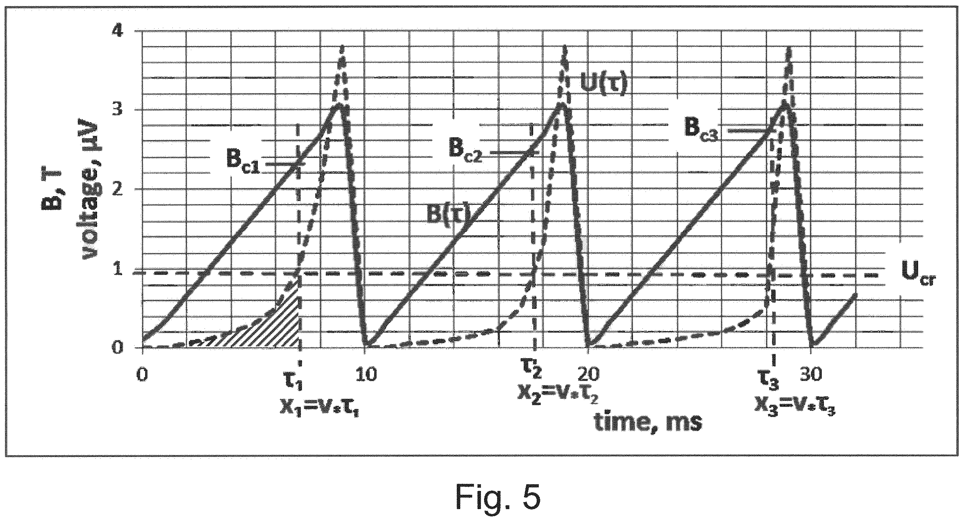

**Fig. 5** illustrates an alternative procedure for measuring the electrical properties of a HTS superconductor as a function of time $\tau$ (illustrated to the right), in a B-sweep variant. The measurement may be performed, for example, on an apparatus as shown in Fig. 1. Note that the time $\tau$ correlates with the location x via the (continuous) translation speed v of the HTS superconductor, with $x=v*\tau$.

Here, the magnetic field applied via the magnetic field generation device is varied in a saw-tooth like manner as a function of time $\tau$. Over a period (cycle duration) of here 10 ms, the magnetic flux density $B(\tau)$ (taken at the magnetic center, so B corresponds to $B_{centr}$) is increased linearly from zero to about 3 Tesla and back to zero here (compare full line). The measurement current is kept constant. The voltage U between the voltage pick-up elements is measured as a function of time, see voltage $U(\tau)$ (compare dashed line). The example illustrates here three measurement cycles (see indices j=1, 2, 3).

For low magnetic flux densities B, the HTS superconductor is practically completely superconducting, and the voltage drop-off U is practically zero. However, when the magnetic flux density B approaches the critical density (for the given temperature $T_{env}$ and measurement current), the voltage U increases in an approximately exponential way. Note that the critical magnetic flux density varies locally due to variations in the structure of the HTS superconductor.

In the example shown, it is assumed that the superconductor has reached its critical magnetic flux density when the voltage U has reached a critical level $U_{cr}$. For each cycle j=1, 2, 3, the time $\tau_j$ is indicated at which $U(\tau)=U_{cr}$. At this point of time, the momentary magnetic flux density $B_{cj}$ is determined, which is considered as the local critical magnetic flux density (at the given measurement current and $T_{env}$ applied during the measurement). The corresponding location along the tape length is determined as $x_j=v^*\tau_j$. In this way, a table of critical magnetic flux densities $B_{cj}$ as a function of location $x_j$ can be obtained. If desired, the critical magnetic flux density may be converted into a corresponding critical current density by appropriate predefined functions.

Alternatively, beginning from the start of each cycle, an integral $\int U(\tau)d\tau$ can be determined. The point of time $\tau_j$ in each cycle j when the integral value reaches a critical value CV is determined, i.e. $\tau_j$ is determined for

which $\int_{\tau 0}^{\tau j} U(\tau)d\tau = \text{CV}$, with $\tau_0$ being the start of the respective cycle. For illustration, the integral area of

$\int_{0}^{\tau 1} U(\tau)d\tau$ is illustrated with a hatching. When the area of the hatching has reached CV, the point of time $\tau_j$ has been reached, and the magnetic flux density $B(\tau_j)$ at this point of time can be considered as the critical magnetic flux density $B_{cj}$ at the respective location $x_j=v^*\tau_j$. Determining $\tau_j$ via the integral $\int U(\tau)d\tau$ is somewhat more complex as compared to a simple limit value Ucr, but thus a higher reliability in determining $B_{cj}$ resp. $I_{cent}^{crit}(x)$ can be obtained.

It should be noted that $I_{centr}^{crit}(x)$ is typically transformed into a critical current $I_{HFLT}^{crit}$ present at a magnetic flux density $B_{high}$, which is typically about 10 Tesla or more, i.e. much larger than $B_{centr}$, and at a temperature $T_{low}$, which is typically at 4.2 K or below, i.e. much lower than $T_{env}$. For this purpose, predefined translation functions may be used, for example applying a lift factor that expresses a ratio of critical currents measured at different fields and temperatures. This procedure is simplified via a reliable correlation of $I_c$ values at B>5T, 4.2 K, where the correlation follows so called alpha-law, i.e. $I_c \sim B^{-alpha}$ where alpha is a known constant for wide field range.

However, for identifying a low quality of or a local defect in a HTS superconductor of known type, a comparison of $I_{centr}^{crit}(x)$ or $B_{cj}(x_j)$ with previously measured HTS superconductors (of verified good quality) is in general sufficient.

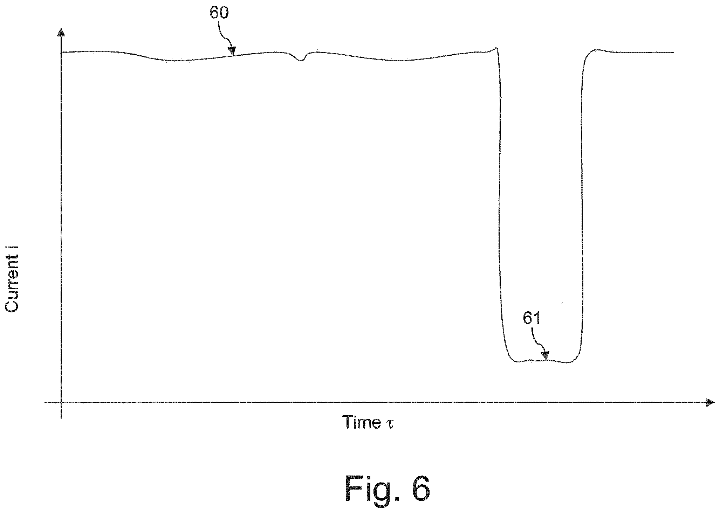

**Fig. 6** illustrates by way of example another procedure for determining the electrical properties of a HTS superconductor according to the invention. The procedure may be performed, in particular, on an inventive apparatus as illustrated in Fig. 1.

In this example, the measurement current i is measured as a function of time $\tau$ during continuous translation of the HTS superconductor. The magnetic flux density is fixed here, and the measurement current at the current exchange elements is controlled such that a voltage drop at the voltage pick-up elements, i.e. across the central region, is kept constant at a predefined value $U_{target}$. The control algorithm includes increasing the measurement current i if the momentary voltage U is below $U_{target}$, and reducing the measurement current i if the momentary voltage U is above $U_{target}$; typically a PD-control (proportional-differential control) is applied. Here, the time for determining the momentary voltage U, comparing it with $U_{target}$, deriving an adapted measurement current i such that U will be at $U_{target}$ again and setting this measurement current i at the current exchange elements defines the cycle duration here.

When the HTS superconductor shows no defects in the section of the HTS superconductor under investigation, the measurement current i typically stays practically constant at a high level 60. Preferably, said high level is close to the critical current $I_{centr}^{crit}$ for the given magnetic field strength and temperature $T_{env}$. However, if a defect (with low or no superconducting current carrying capacity) gets into this section, the measurement current i drops to a significantly lower level 61.

In summary, the present invention proposes to evaluate the electrical properties, in particular the critical current, of a HTS superconductor (3), in particular of coated conductor tape type, wherein a measurement current (i) is injected into an active part/characterization zone (4) of the HTS superconductor, wherein the active part is cooled, but not reservoirs (1, 2) of the HTS superconductor from and to which the HTS superconductor is wound continuously, and exposing only a fraction of the active part to a magnetic field for testing the electrical properties, with the magnetic field for testing having 1.5 T or more, in particular 2 T or more, and typically being oriented perpendicular to a tape flat side, wherein protection means/buffer devices (20a, 20b) are provided against current sharing with respect to outside the active part, wherein injection of the measurement current is done where the residual magnetic field is at least 3 times lower as compared to the magnetic field for testing and/or the local critical current at the current injection locations is at least three times higher as compared to the critical current at the magnetic field for testing. Preferably, current injection is done where the magnetic field has an opposite sign as compared to the magnetic field of testing. Evaluation of the electrical properties, in particular the evaluation of the critical current, may be done by determining an integral of a voltage drop (U) across the active part or a fraction of the active part, e.g. between two voltage pick-up elements (15a, 15b), as a function of measurement time ($\tau$), in particular comparing the integral value to a critical value (CV) and determining the corresponding time when the critical value was reached. The inventive method is less susceptible to measurement errors. This may be very well seen in the case when some local defect that reduces local critical current enters the characterization zone. When this defect reaches high field zone (central region), it will cause a constant addition to the voltage drop until the defect come out of high field zone. Additionally this defect will contribute to measured voltage drop when it passes the through the transient zones (peripheral regions) with field gradient. At evaluation stage these effects may be taken into account using a first time (or coordinate) derivative from the voltage drop or the integral voltage drop; note that the voltage drop or integral voltage drop has to be examined at identical boundary conditions, such as at identical magnetic field strength and measurement current strength, e.g. at identical relative points during measurement cycles, in each case. For example, there is a stepwise increase of voltage drop with a positive peak of first derivative when local defect enters the characterization zone. Accordingly, there is a stepwise reduction of voltage drop with a negative peak of the first derivative when defect comes out of the characterization zone with high magnetic field. These relationships significantly improve the linear resolution, accuracy and stability of the characterization procedure.

List of reference signs

| | |
|---|---|
| 1 | first reservoir |
| 2 | second reservoir |
| 3 | HTS superconductor |
| 4 | characterization zone |
| 5 | reel drive |
| 6 | cryogenic zone |
| 7 | cryovessel (cryostat) |
| 8 | cover (cryostat) |
| 9 | guiding element (last on first reservoir side) |
| 10 | guiding element (first on second reservoir side) |
| 11 | cryogenic environment |
| 12a | first current exchange element |
| 12b | second current exchange element |
| 13a | electrical line/wire (current lead) |
| 13b | electrical line/wire (current lead) |
| 14 | inner base frame |
| 15a | first voltage pick-up element |
| 15b | second voltage pick-up element |
| 16a | electrical line/wire (voltage lead) |
| 16b | electrical line/wire (voltage lead) |
| 17 | magnetic field generation device (magnet) |
| 18 | cleavage |
| 19 | current lead (current lead of magnet) |
| 20a | buffer device |
| 20b | buffer device |
| 21a | first buffer zone |
| 21b | second buffer zone |
| 22a | first decoupling section |
| 22b | second decoupling section |
| 23 | central region |
| 24a | peripheral region |
| 24b | peripheral region |
| 25 | ferromagnetic shielding |
| 26 | LN2 nozzle and level sensor |
| 27 | controller device |
| 28 | pendant |
| 29 | base plate |
| 30 | magnetic field lines |
| 31 | magnetic center |
| 60 | high level |
| 61 | lower level |
| 71 | maximum |
| 72 | minimum |
| 100 | apparatus |
| B | magnetic flux density |
| $B_{cj}$ | determined critical magnetic flux density |
| i | measurement current |
| $I_{cj}$ | determined critical current in cycle j |
| j | cycle index |
| $\tau$ | time |
| U | voltage |
| $U_{cr}$ | critical voltage |
| v | translation speed |
| x | location on HTS superconductor |
| $\hat{x}$ | location with respect to magnetic center |

**Claims**

1. A method for evaluating the electrical properties of a HTS superconductor (3), in particular a HTS superconductor tape,
   wherein the HTS superconductor (3) is exposed to a cryogenic environment (11) of a temperature $T_{env}$,
   wherein the HTS superconductor (3) passes through a characterization zone (4) where a magnetic field is applied to the HTS superconductor (3), wherein the characterization zone (4) comprises a central region (23) and two peripheral regions (24a, 24b) through which the HTS superconductor (3) passes, and wherein the HTS superconductor (3) is supplied with a measuring current (i) by two current exchange elements (12a, 12b), wherein one of the current exchange elements (12a, 12b) contacts the HTS superconductor (3) in each peripheral region (24a, 24b),
   **characterized in**
   **that** the HTS superconductor (3) is continuously translated from a first reservoir (1) through the characterization zone (4) to a second reservoir (2),
   **that** the HTS superconductor (3) is exposed to the cryogenic environment (11) only in a cryogenic zone (6), wherein the cryogenic zone (6) includes the characterization zone (4) and wherein the first and second reservoir (1, 2) are located outside the cryogenic zone, (6)
   **that** the HTS superconductor (3) passes two buffer zones (21a, 21b) where two decoupling sections (22a, 22b) are created in the HTS superconductor (3), with a first decoupling section (22a) established between the first reservoir (1) and the characterization zone (4), and a second decoupling section (22b) established between the characterization zone (4) and the second reservoir (2),

that the magnetic field is chosen such that a maximum magnetic flux density at the HTS superconductor (3) in the central region (23) is $B_{centr}$, with $B_{centr} \geq 1.5$ Tesla, and a maximum magnetic flux density at the HTS superconductor (3) at the current exchange elements (12a, 12b) is $B_{peri}$, such that, at the temperature $T_{env}$ of the HTS superconductor (3) established by the cryogenic environment (11) in the characterization zone (4), for a critical current $I_{centr}^{crit}$ of the HTS superconductor (3) in the central region (23) and a critical current $I_{peri}^{crit}$ of the HTS superconductor (3) at the current exchange elements (12a, 12b), the following applies:

$$I_{peri}^{crit} \geq 3*I_{centr}^{crit},$$

and that in each buffer zone (21a, 21b), the HTS superconductor (3) is treated such that

- the HTS superconductor (3) becomes normally conducting within the decoupling section (22a, 22b), or
- a local critical current $I_{buffer}^{crit}$ of the HTS superconductor (3) in the decoupling section (22a, 22b) is assumed with $I_{buffer}^{crit} \leq 1/50*I_{centr}^{crit}$.

2. A method according to claim 1, **characterized in that** $B_{centr}$ and $B_{peri}$ are chosen such that

$$I_{peri}^{crit} \geq 5*I_{centr}^{crit}$$

preferably $I_{peri}^{crit} \geq 10*I_{centr}^{crit}$,
most preferably $I_{peri}^{crit} \geq 20*I_{centr}^{crit}$.

3. A method according to claim 1 or 2, **characterized in that** $B_{centr}$ and $B_{peri}$ are chosen with

$$B_{peri} \leq 0.3*B_{centr},$$

preferably $B_{peri} \leq 0.2*B_{centr}$,
more preferably $B_{peri} \leq 0.1*B_{centr}$,
most preferably $B_{peri} \leq 0.05*B_{centr}$.

4. A method according to one of the preceding claims, **characterized in that** the first decoupling section (22a) of the HTS superconductor (3) is established between a last guiding element (9) of the HTS superconductor (3) fed from the first reservoir (1) and a first current exchange element (12a) of the current exchange elements (12a, 12b), and the second decoupling section (22b) of the HTS superconductor (3) is established between a second current exchange element (12b) of the current exchange elements (12a, 12b) and a first guiding element (10) of the HTS superconductor (3) fed to the second reservoir (2).

5. A method according to one of the preceding claims, **characterized in that** in the buffer zones (21a, 21b), the HTS superconductor (3) undergoes

a) an active heating, in particular an electrical heating, to a temperature $T_{buffer}$, with $T_{buffer} > T_{env}$, preferably $T_{buffer} >$ room temperature, and/or
b) exposure to a jamming magnetic field that suppresses the local critical current $I_{buffer}^{crit}$.

6. A method according to one of the preceding claims, **characterized in that** the current exchange elements (12a, 12b) are positioned such that a local direction of the magnetic field at the current exchange elements (12a, 12b) is opposite to the direction of the magnetic field in the central region (23) at the HTS superconductor (3).

7. A method according to any one of the preceding claims, **characterized in that** a voltage drop $V_{drop}$ (U) at least across the central region (23) of the HTS superconductor (3) is monitored using two voltage pick-up elements (15a, 15b),
in particular wherein the voltage pick-up elements (15a, 15b) contact the HTS superconductor (3) between the current exchange elements (12a, 12b).

8. The method according to claim 7, **characterized in that** the method is conducted such that for the voltage drop $V_{drop}$ (U), the following applies

$$0.5 \ \mu V \leq V_{drop} \leq 2 \ V,$$

preferably $0.5 \ \mu V \leq V_{drop} \leq 1 \ V$,
most preferably $1 \ \mu V \leq V_{drop} \leq 1 \ V$.

9. A method according to one of the claims 7 or 8, **characterized in that** the voltage pick-up elements (15a, 15b) are connected to electrical wires (16a, 16b), and that at least a part of one or both of the electrical wires (16a, 16b) is guided within the characterization zone (4) together with the HTS superconductor (3) through a cleavage (18) of a magnetic field generation device (17).

10. A method according to one of the claims 7 through 9, **characterized in that** a probing voltage drop ($\hat{U}$)

as a function of time ($\tau$) or location (x) on the HTS superconductor (3) is determined, wherein for determining the probing voltage drop (U),

- the voltage drop (U) is repeatedly read out at an identical respective magnetic field strength and at an identical respective measurement current value,
- or the voltage drop (U) is integrated during repeated congeneric cycles of sweeps of the measuring current (i) or the magnetic field until an identical measurement current value or an identical magnetic field strength has been reached in each case,

that a first derivative with respect to the time ($\tau$) or location (x) of the probing voltage drop ($\hat{U}$) is determined,
and that a transport of a defect of the HTS superconductor (3) through the characterization zone (4) during the continuous translation is established by identifying a maximum (71) of the first derivative of the probing voltage drop ($\hat{U}$) followed by a minimum (72) of the first derivative of the probing voltage drop ($\hat{U}$).

11. A method according to any one of the preceding claims, **characterized in that** the evaluation of the electrical properties of the HTS superconductor (3) includes

a) applying a constant magnetic field in the characterization zone (4), applying a sweep of the measuring current (i), and monitoring a voltage drop (U) at least across the central region (23) along the HTS superconductor (3), or
b) applying a constant magnetic field in the characterization zone (4), and regulating and monitoring the measuring current (i) such that a constant voltage drop ($U_{target}$) at least across the central region (23) along the HTS superconductor (3) is obtained, or
c) applying a sweep of the magnetic field (B) in the characterization zone (4), applying a constant measuring current (i), and monitoring a voltage drop (U) at least across the central region (23) along the HTS superconductor (3).

12. A method according to claim 11, **characterized in that** the method is conducted such that for a cycle duration CD of the sweep of the measuring current (i) and/or of the sweep of the magnetic field (B), or a cycle duration CD of regulating the measuring current (i) to re-establish the constant voltage drop ($U_{target}$), the following applies:

$$0.5 \text{ ms} \leq CD \leq 100 \text{ ms}.$$

13. A method according to any one of the preceding claims, **characterized in that** the evaluation of the electrical properties includes evaluating the critical current $I_{centr}^{crit}$ of the HTS superconductor (3) at the temperature $T_{env}$ established by the cryogenic environment (11) and at the maximum magnetic flux density $B_{centr}$.

14. The method according to any one of the preceding claims, **characterized in that** $B_{centr}$ is chosen with

$$B_{centr} \leq 6 \text{ Tesla},$$

preferably $B_{centr} \leq 4$ Tesla,
and that $T_{env}$ is chosen with $T_{env} \geq 24$ K,
preferably $T_{env} \geq 77$ K.

15. The method according to claim 13 and claim 14, **characterized in that** the evaluation of electrical properties further includes estimating a high field low temperature critical current $I_{HFLT}^{crit}$ for the HTS superconductor (3) at a magnetic flux density $B_{high}$ and at a temperature $T_{low}$ based on $I_{centr}^{crit}$, with

$$B_{high} \geq 3 * B_{centr},$$

preferably $B_{high} \geq 10$ Tesla,
most preferably $B_{high} \geq 15$ Tesla,
and further with
$T_{low} \leq 4.2$ K.

16. The method according to one of the preceding claims, **characterized in that** the magnetic field is shaped using a ferromagnetic screening (25).

17. An apparatus (100) for evaluating the electrical properties of a HTS superconductor (3), in particular a HTS superconductor tape, designed for performing a method as described in one of the preceding claims.

EP 3 671 247 A1

16a

3 9 20a 13a 26 28 19 27 16a/ 13b 10 5
16b

21a/22a 21b/22b

20b

4 24a/24b

23

16b

6/11

100

1 2

24a 23 24b

4

29 8 7 15a 14 17 25 15b 3 12b
12a 18

Fig. 1

Fig. 2a

Fig. 2b

Fig. 3

Fig. 4

EP 3 671 247 A1

Fig. 5

Fig. 6

Fig. 7

Europäisches
Patentamt

European
Patent Office

Office européen
des brevets

# EUROPEAN SEARCH REPORT

Application Number

EP 18 21 3831

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2010/026292 A1 (COULTER J YATES [US] ET AL) 4 February 2010 (2010-02-04)<br>* abstract; figures 1-20 *<br>* paragraph [0040] - paragraph [0050] *<br>* paragraph [0055] *<br>* paragraph [0072] *<br>* paragraph [0063] - paragraph [0064] *<br>----- | 1-9, 11-17<br>10 | INV.<br>G01R33/12 |
| A | EP 1 760 479 A2 (INT SUPERCONDUCTIVITY TECH [JP]; FUJIKURA LTD [JP])<br>7 March 2007 (2007-03-07)<br>* abstract; figures 1,2 *<br>* paragraph [0062] - paragraph [0064] *<br>----- | 1-17 | |
| A | US 2012/249171 A1 (BAECKER MICHAEL [DE] ET AL) 4 October 2012 (2012-10-04)<br>* abstract; figures 1,2 *<br>* paragraph [0062] - paragraph [0066] *<br>* paragraph [0066] *<br>----- | 1-17 | |
| A,D | US 2007/149411 A1 (XIE YI-YUAN [US] ET AL) 28 June 2007 (2007-06-28)<br>* abstract; figures 2,3 *<br>* paragraph [0029] - paragraph [0035] *<br>* paragraph [0004] *<br>----- | 1-17 | TECHNICAL FIELDS SEARCHED (IPC)<br><br>G01R |

The present search report has been drawn up for all claims

| Place of search | Date of completion of the search | Examiner |
|---|---|---|
| Munich | 9 July 2019 | Böhm-Pélissier, A |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 18 21 3831

This annex lists the patent family members relating to the patent documents cited in the above-mentioned European search report.
The members are as contained in the European Patent Office EDP file on
The European Patent Office is in no way liable for these particulars which are merely given for the purpose of information.

09-07-2019

| Patent document cited in search report | Publication date | Patent family member(s) | Publication date |
|---|---|---|---|
| US 2010026292 A1 | 04-02-2010 | US 2008088304 A1<br>US 2010026292 A1 | 17-04-2008<br>04-02-2010 |
| EP 1760479 A2 | 07-03-2007 | EP 1760479 A2<br>JP 4579107 B2<br>JP 2007071659 A<br>US 2007108974 A1 | 07-03-2007<br>10-11-2010<br>22-03-2007<br>17-05-2007 |
| US 2012249171 A1 | 04-10-2012 | DE 102010011536 A1<br>DK 2476006 T3<br>EP 2476006 A1<br>ES 2436565 T3<br>JP 5623532 B2<br>JP 2013504748 A<br>KR 20120090980 A<br>US 2012249171 A1<br>WO 2011029669 A1 | 24-03-2011<br>20-01-2014<br>18-07-2012<br>03-01-2014<br>12-11-2014<br>07-02-2013<br>17-08-2012<br>04-10-2012<br>17-03-2011 |
| US 2007149411 A1 | 28-06-2007 | US 2007149411 A1<br>WO 2008010845 A2 | 28-06-2007<br>24-01-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070149411 A1

**Non-patent literature cited in the description**

- **L. ROSSI et al.** Sample and length-dependent variability of 77 and 4.2 K properties in nominally identical RE123 coated conductors. *Superconductor Science and Technology,* 2016, vol. 29 (5), 054006